# EUROPEAN PATENT APPLICATION

(11) **EP 4 565 025 A1**
(43) Date of publication of application: **04.06.2025**
(21) Application number: 24215764.2
(22) Date of filing: 27.11.2024
(51) Int. Cl.: H10B 51/20, H10B 51/30, H10D 30/01, H10D 30/69, H10D 64/01, H10D 64/68

(54) **SEMICONDUCTOR DEVICE AND MEMORY DEVICE INCLUDING THE SAME**

(30) Priority: 29.11.2023 KR 20230169854
(71) Applicant: Samsung Electronics Co., Ltd., Suwon-si, Gyeonggi-do 16677 (KR)
(72) Inventor: YOO, Sijung, 16678 Suwon-si (KR); NAM, Seunggeol, 16678 Suwon-si (KR); LEE, Woochul, 16678 Suwon-si (KR); LEE, Hyunjae, 16678 Suwon-si (KR); CHOE, Dukhyun, 16678 Suwon-si (KR); CHOI, Seokhoon, 16678 Suwon-si (KR); HYUN, Seungdam, 16678 Suwon-si (KR)
(74) Representative: Elkington and Fife LLP

(57) **Abstract**

Provided are a semiconductor device (100) and a memory device including the same. The semiconductor device includes a channel layer (115), a ferroelectric layer (130) on the channel layer, a charge trap layer (140) on the ferroelectric layer, a barrier modulation layer (150) on the charge trap layer, a tunneling barrier layer (160) on the barrier modulation layer, and a gate electrode (170) on the tunneling barrier layer. The barrier modulation layer is configured to have high electron affinity compared to the tunneling barrier layer and the charge trap layer and to have a low bandgap compared to the tunneling barrier layer and the charge trap layer.

## Description

### FIELD OF THE INVENTION

Various example embodiments relate to a semiconductor device and a memory device including the same.

### BACKGROUND OF THE INVENTION

As memory devices become smaller and highly integrated, vertical NAND flash memory devices including a plurality of memory cells stacked in a direction perpendicular to a substrate have been developed. In recent years, research has been conducted to apply ferroelectric field effect transistors (FeFETs), which have low operating voltages and fast programming speed, to vertical NAND flash memory devices. FeFETs are semiconductor devices in which memory characteristics are implemented by adjusting threshold voltages according to a polarization direction of ferroelectric materials. The FeFET devices are fabricated by forming gate insulating films including ferroelectric materials.

### SUMMARY OF THE INVENTION

Various example embodiments include a semiconductor device and/or a memory device including the same.

Additional aspects will be set forth in part in the description which follows and, in part, will be apparent from the description, or may be learned by practice of the presented example embodiments.

According to one or more example embodiments, a semiconductor device includes a channel layer, a ferroelectric layer on the channel layer, a charge trap layer on the ferroelectric layer, a barrier modulation layer on the charge trap layer, a tunneling barrier layer on the barrier modulation layer, and a gate electrode on the tunneling barrier layer. The barrier modulation layer is configured to have high electron affinity compared to the tunneling barrier layer and the charge trap layer and configured to have a low bandgap compared to the tunneling barrier layer and the charge trap layer.

Alternatively or additionally according to one or more example embodiments, a semiconductor device includes a channel layer, a ferroelectric layer on the channel layer, a barrier modulation layer on the ferroelectric layer, a tunneling barrier layer on the barrier modulation layer and including silicon oxide or aluminum oxide, and a gate electrode on the tunneling barrier layer. The barrier modulation layer is configured to have high electron affinity compared to the tunneling barrier layer and the ferroelectric layer and to have a low bandgap compared to the tunneling barrier layer and the ferroelectric layer.

Alternatively or additionally according to one or more example embodiments, a memory device includes a plurality of cell arrays, wherein each of the plurality of cell arrays includes a channel layer extending perpendicular to a substrate, a ferroelectric layer on the channel layer, a charge trap layer on the ferroelectric layer, a barrier modulation layer on the charge trap layer, a tunneling barrier layer on the barrier modulation layer, and a plurality of gate electrodes on the tunneling barrier layer. The barrier modulation layer is configured to have high electron affinity compared to the tunneling barrier layer and the charge trap layer and to have a low bandgap compared to the tunneling barrier layer and the charge trap layer.

### BRIEF DESCRIPTION OF THE DRAWINGS

The above and other aspects, features, and advantages of certain example embodiments will be more apparent from the following description taken in conjunction with the accompanying drawings, in which:
FIG. 1 is a cross-sectional view schematically illustrating a semiconductor device according to some example embodiments;
FIG. 2 illustrates a band diagram of the semiconductor device shown in FIG. 1;
FIGS. 3A and 3B illustrate results of measuring an amount of charges tunneled toward a gate electrode according to a potential barrier of electrons;
FIGS. 4A through 4C illustrate band diagrams of semiconductor devices including a SiO₂ tunneling barrier layer and a SiN charge trap layer;
FIG. 5 is a cross-sectional view schematically illustrating a semiconductor device according to some example embodiments;
FIGS. 6A through 6C illustrate band diagrams of semiconductor devices including a SiO₂ tunneling barrier layer and a HZO ferroelectric layer;
FIG. 7 is a cross-sectional view schematically illustrating a semiconductor device according to some example embodiments;
FIG. 8 illustrates a band diagram of the semiconductor device shown in FIG. 7;
FIG. 9 is a perspective view schematically illustrating a memory device according to some example embodiments;
FIG. 10 illustrates a cross-section of a cell array shown in FIG. 9;
FIG. 11 is an enlarged view of a portion B of FIG. 10;
FIG. 12 is a cross-sectional view of a memory device according to some example embodiments;
FIG. 13 is a cross-sectional view of a memory device according to some example embodiments;
FIG. 14 is a conceptual view schematically illustrating a device architecture that may be applied to an electronic apparatus;
FIG. 15 is a block diagram illustrating a memory system according to some example embodiments; and
FIG. 16 is a block diagram illustrating a neuromorphic apparatus and an external device connected to the neuromorphic apparatus, according to some example embodiments.

### DETAILED DESCRIPTION

Reference will now be made in detail to various embodiments, examples of which are illustrated in the accompanying drawings, wherein like reference numerals refer to like elements throughout. In this regard, the present embodiments may have different forms and should not be construed as being limited to the descriptions set forth herein. Accordingly, the provided example embodiments are merely described below, by referring to the figures, to explain aspects. As used herein, the term "and/or" includes any and all combinations of one or more of the associated listed items. Expressions such as "at least one of," when preceding a list of elements, modify the entire list of elements and do not modify the individual elements of the list.

Hereinafter, some example embodiments will be described in detail with reference to the accompanying drawings. In the following drawings, the same reference numerals refer to the same component, and the size of each component in the drawings may be exaggerated for clarity and convenience of explanation. On the other hand, embodiments to be described below are only an example, and various variations are possible from these embodiments.

Hereinafter, when a portion is described as "above" or "on" another portion may include the case where the portion is at the top, bottom, left, and right in a noncontact manner, as well as in contact with the top, bottom, left, and right. The singular expression includes a plurality of expressions unless the context is clearly different. In addition, when a portion "includes" a component, it means that it may further include other components, not excluding other components unless particularly stated to the contrary.

The use of the terms of "above" and the use of similar indicators may correspond to both singular and plurality. If the order is clearly described for steps for configuring a method or there is no opposite description, these steps can be performed in the right order, and are not necessarily limited to the order described.

In addition, terms such as "..." and "module" described in the specification are units of processing at least one function or operation, which can be implemented by hardware or software or by combining hardware and software.

Connections or connection members of lines between components shown in the drawings show functional connections and/or physical or circuit connections, which are shown as replaceable or additional functional connections, physical connections or circuit connections in an actual devices.

The use of all examples or exemplary terms is intended simply to describe the technical detail, and the scope is not limited due to these examples or exemplary terms unless it is limited by the claims.

A ferroelectric field effect transistor (FeFET) is or includes a memory device that uses the characteristic of changing the threshold voltage of the transistor by switching of spontaneous polarization. The FeFET may have two or more threshold voltages, e.g., a minimum threshold voltage and a maximum threshold voltage that are determined by the polarization state of ferroelectrics, and various threshold voltages therebetween. These threshold voltages may be nonvolatile and insensitive to the application of an external power supply, and multiple information are stored through these threshold voltages so that multi-level memory may be implemented. Here, a memory window (MW) in which a difference between the minimum threshold voltage and the maximum threshold voltage corresponds to a sensing margin, may be configured. Securing the MW by as much as possible may be desirable, so that a memory device based on the FeFET may achieve a sufficiently large number of multi-levels.

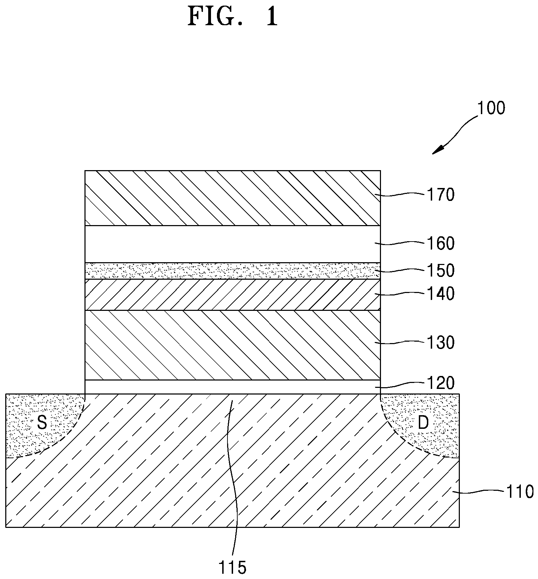

FIG. 1 is a cross-sectional view schematically illustrating a semiconductor device 100 according to some example embodiments. The semiconductor device 100 shown in FIG. 1 may be a FeFET. The semiconductor device 100 may constitute a memory cell of a memory device to be described later.

Referring to FIG. 1, a semiconductor device 100 may include a semiconductor substrate 110, a ferroelectric layer 130, a charge trap layer 140, a barrier modulation layer 150, a tunneling barrier layer 160, and a gate electrode 170. A channel element 115 may be formed in an upper region of the semiconductor substrate 110 to correspond to the gate electrode 170, and a first region, e.g., a source region S and a second region, e.g., a drain region D may be formed at both sides of the channel element 115. The semiconductor substrate 110 may include halo or pocket implant regions proximate to the source region S and/or the drain region D; example embodiments are not limited thereto.

The semiconductor substrate 110 may include, for example, an IV-group semiconductor such as one or more of silicon (Si), germanium (Ge), silicon germanium (SiGe), and/or an III-V-group semiconductor compound. The semiconductor substrate 110 may include, for example, one or more of an oxide semiconductor, a nitride semiconductor, an oxynitride semiconductor, a two-dimensional (2D) semiconductor material, a quantum dot, or an organic semiconductor. Here, the oxide semiconductor may include, for example, InGaZnO, or the like, and the 2D semiconductor material may include, for example, transition metal dichalcogenide (TMD) and/or graphene, and the quantum dot may include one or more of a colloidal QD, a nanocrystal structure, or the like. However, this is just an example, and embodiments are not limited thereto.

The semiconductor substrate 110 may further include a dopant. The dopant may include a p-type dopant and/or a n-type dopant. The p-type dopant may include, for example, a group III element such as one or more of boron (B), aluminum (Al), gallium (Ga), indium (In) or the like, and the n-type dopant may include, for example, a group V element such as one or more of phosphorus (P), arsenic (As), antimony (Sb) or the like. For example, the semiconductor substrate 110 may be a p-Si substrate on which Si is doped with the p-type dopant, or a n-Si substrate on which Si is doped with the n-type dopant. However, this is just an example. In some further examples, the semiconductor substrate may include both p-type dopants and n-type dopants at vastly different concentrations; example embodiments are not limited thereto.

An interfacial layer 120 may be formed on the surface of the semiconductor substrate 110. The interfacial layer 120 may be or may include an oxide and/or a nitride of the semiconductor substrate 110, but embodiments are not limited thereto. For example, when the semiconductor substrate 110 includes silicon, the interfacial layer 120 may include silicon oxide.

The gate electrode 170 may be arranged above the semiconductor substrate 110. The gate electrode 170 may include, for example, metal and/or metal nitride. Metal may include, for example, one or more of Al, tungsten (W), molybdenum (Mo), titanium (Ti) or tantalum (Ta), and metal nitride may include, for example, titanium nitride (TiN) and/or tantalum nitride (TaN).

The gate electrode 170 may include one or more of metal carbide, polysilicon such as doped polysilicon or a 2D conductive material. The metal carbide may be metal carbide doped with Al and/or Si. As a specific example, the metal carbide may include one or more of TiAlC, TaAIC, TiSiC or TaSiC. The gate electrode 170 may also have a structure in which a plurality of materials are stacked. For example, the gate electrode 170 may have a stack structure of a metal nitride layer/a metal layer, such as TiN/Al, or a stack structure of a metal nitride layer/a metal carbide layer/a metal layer, such as TiN/TiAlC/W.

The ferroelectric layer 130 may be between the semiconductor substrate 110 and the gate electrode 170. The ferroelectric is or includes a material with ferroelectricity that maintains spontaneous polarization, aligned by an internal electric dipole moment. The ferroelectric material has remnant polarization by dipole even in a state where an electric field is not applied from the outside. In addition, in the ferroelectrics, the direction of polarization may be switched in units of domain by an external electric field.

The ferroelectric layer 130 may include, for example, at least one of a fluorite-based material, perovskite, or nitride-based material. Here, "fluorite" and "perovskite" refer to the particular configuration/motif of the material. The fluorite-based material may include, for example, at least one oxide selected from the group consisting of or including hafnium (Hf), Si, Al, zirconium (Zr), yttrium (Y), lanthanum (La), gadolinium (Gd), or strontium (Sr), and may or may not include fluorine. As a specific example, the fluorite-based material may include at least one of hafnium oxide (HfO), zirconium oxide (ZrO), or hafnium-zirconium oxide (HfZrO). Perovskite may include, for example, PZT, BaTiOs, PbTiOs, or the like, and embodiments are not limited thereto. The nitride-based material may include, for example, AlScN, but embodiments are not limited thereto.

The ferroelectric layer 130 may further include a certain dopant. For example, the ferroelectric layer 130 may include a material in which a certain dopant is inserted into at least one of HfO, ZrO, or HfZrO. Here, the certain dopant may include, for example, at least one of Zr, La, Al, Si, or Y, at the same or at different concentrations. However, example embodiments are not limited thereto.

The tunneling barrier layer 160 may be between the ferroelectric layer 130 and the gate electrode 170. The tunneling barrier layer 160 may be configured to screen polarization at an upper interface of the ferroelectric layer 130 by charges introduced through tunneling. Thus, due to the effect that, as a space between the ferroelectric layer 130 and the gate electrode 170 is increased, capacitance is reduced, the MW may be increased.

In the tunneling barrier layer 160, tunneling should occur briskly at a high voltage, and in a standby voltage, charges introduced into the tunneling barrier layer 160 need not to be discharged. The tunneling barrier layer 160 may include, for example, silicon oxide (SiO₂). However, this is just an example, and the tunneling barrier layer 160 may include other various materials. For example, the tunneling barrier layer 160 may include aluminum oxide (Al₂O₃).

The charge trap layer 140 may be between the tunneling barrier layer 160 and the ferroelectric layer 130. The charge trap layer 140 may be or may correspond to a layer for trapping charges between the tunneling barrier layer 160 and the ferroelectric layer 130, and the charges trapped by the charge trap layer 140 are added to the charges tunneled through the tunneling barrier layer 160 so that the increase effect of the MW may be increased or maximized. The charge trap layer 140 may include, for example, silicon nitride (SiN). However, embodiments are not limited thereto.

The barrier modulation layer 150 may be between the tunneling barrier layer 160 and the charge trap layer 140. The barrier modulation layer 150 may be configured to increase a potential barrier of electrons. The barrier modulation layer 150 may include a material having high electronic affinity and a low bandgap compared to the tunneling barrier layer 160, and also as compared to the charge trap layer 140.

In a general semiconductor device, the tunneling barrier layer may include mainly silicon oxide (SiO₂), and the charge trap layer may include mainly silicon nitride (SiN). In a state where an external voltage is not applied to the semiconductor device including the tunneling barrier layer and the charge trap layer, the charges trapped on the charge trap layer may be discharged to the gate electrode. In this case, since the potential barrier of electrons is very low compared to the potential barrier of holes, the electrons may be more easily discharged to the gate electrode compared to the holes. This may result in a worse result in the retention characteristics in an erasing operation state compared to a programming operating state.

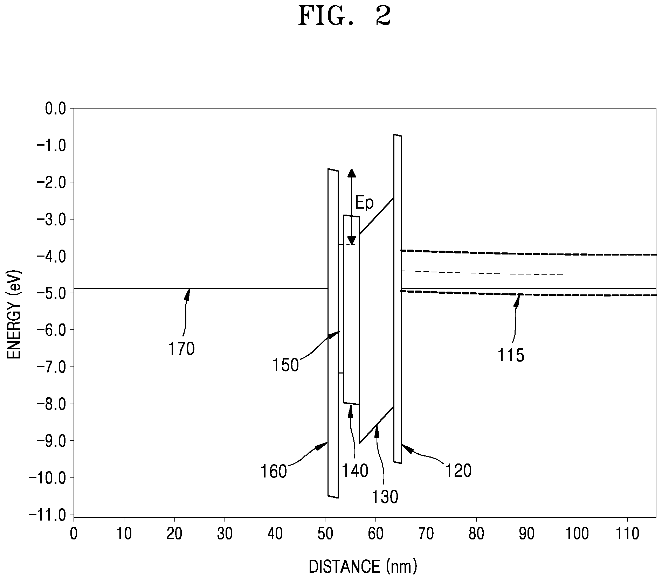

FIG. 2 schematically illustrates a band diagram (or Fermi diagram) of the semiconductor device 100 shown in FIG. 1. Referring to FIG. 2, the barrier modulation layer 150 including a material having high electron affinity and a low bandgap compared to the tunneling barrier layer 160 and the charge trap layer 140 may be inserted between the tunneling barrier layer 160 and the charge trap layer 140 so that a potential barrier Ep of electrons may be increased, as compared to the case where there is no barrier modulation layer 150.

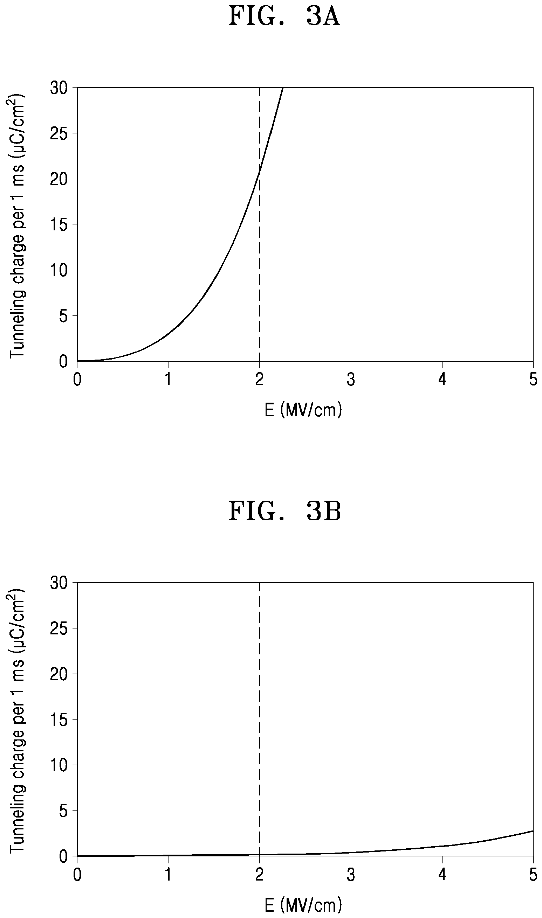

FIGS. 3A and 3B illustrate results of measuring an amount of charges tunneled toward a gate electrode according to a potential barrier of electrons. In FIGS. 3A and 3B, the tunneling barrier layer includes silicon oxide having a thickness of 2 nm.

FIG. 3A illustrates that the amount of charges tunneled toward the gate electrode for 1 ms according to the intensity of an electric field applied to the tunneling barrier layer when the potential barrier of electrons is 2 eV. FIG. 3B illustrates that the amount of charges tunneled toward the gate electrode for 1 ms according to the intensity of an electric field applied to the tunneling barrier layer when the potential barrier of electrons is 3 eV. Referring to FIGS. 3A and 3B, when the electric field of about 2 MV/cm is applied to the tunneling barrier layer, in the case where the potential barrier of electrons is 3 eV, the amount of charges tunneled toward the gate electrode may be further reduced as compared to the case where the potential barrier of electrons is 2 eV, and this indicates that a tunneling current flowing through the gate electrode is greatly reduced. In this way, as the potential barrier of electrons is increased, the retention characteristics in an erasing operation state may be enhanced.

According to various example embodiments, the barrier modulation layer 150 that may be configured to increase the potential barrier Ep of electrons as compared to the potential barrier Eh of holes may be inserted between the tunneling barrier layer 160 and the charge trap layer 140, so that the amount of electrons discharged to the gate electrode 170 is reduced. Thus, the retention characteristics in the erasing operation state may be improved upon or enhanced. The barrier modulation layer 150 may include a material having high electronic affinity and a low bandgap compared to both the tunneling barrier layer 160 and the charge trap layer 140. The barrier modulation layer 150 may include a material in which the sum of electron affinity and a bandgap is 8 eV or less. However, example embodiments are not limited thereto. The barrier modulation layer 150 may include, for example, one or more of TiO₂, Ta₂O₅, SrTiOs, or ZnO. The barrier modulation layer 150 may have a thickness of about 0.1 nm to about 5 nm, but embodiments are not limited thereto.

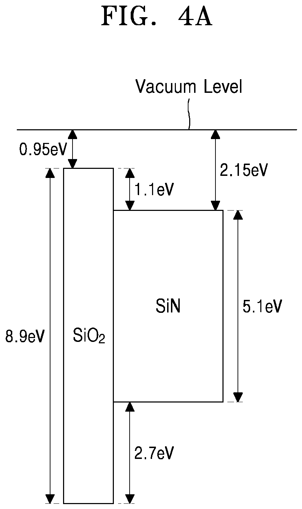

FIGS. 4A through 4C illustrate band diagrams of semiconductor devices including a SiO₂ tunneling barrier layer and a SiN charge trap layer.

FIG. 4A illustrates a band diagram of a semiconductor device in which there is no barrier modulation layer between the SiO₂ tunneling barrier layer and the SiN charge trap layer. Referring to FIG. 4A, the electron affinity and the bandgap of the SiO₂ tunneling barrier layer are 0.95 eV and 8.9 eV, respectively. The electron affinity and bandgap of the SiN charge trap layer are 2.15 eV and 5.1 eV, respectively. The potential barrier of electrons between the SiO₂ tunneling barrier layer and the SiN charge trap layer is 1.1 eV, and the potential barrier of holes is 2.7 eV.

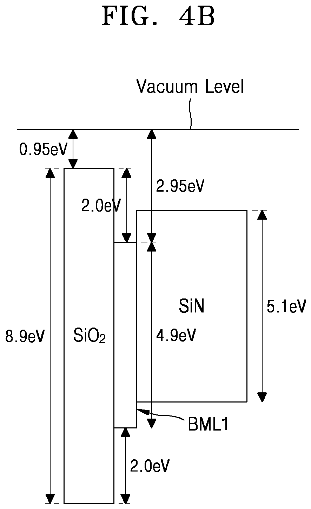

FIG. 4B illustrates a band diagram of a semiconductor device in which a first barrier modulation layer BML1 is between the SiO₂ tunneling barrier layer and the SiN charge trap layer. Referring to FIG. 4B, the first barrier modulation layer BML1 may have high electron affinity and a low bandgap as compared to the SiO₂ tunneling barrier layer and to the SiN charge trap layer. Specifically, the electron affinity and the bandgap of the first barrier modulation layer BML1 are 2.95 eV and 4.9 eV, respectively. Thus, the sum of electron affinity and bandgap of the first barrier modulation layer BML1 is 7.85 eV. The potential barrier of electrons between the SiO₂ tunneling barrier layer and the first barrier modulation layer BML1 is 2.0 eV, and this is increased compared to the case of FIG. 4A.

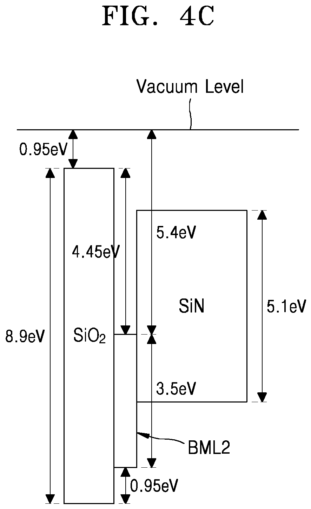

FIG. 4C illustrates a band diagram of a semiconductor device in which a second barrier modulation layer BML2 is between the SiO₂ tunneling barrier layer and the SiN charge trap layer. Referring to FIG. 4C, the second barrier modulation layer BML2 has high electron affinity and a low bandgap compared to the SiO₂ tunneling barrier layer and the SiN charge trap layer. Specifically, the electron affinity and a bandgap of the second barrier modulation layer BML2 are 5.4 eV and 3.5 eV, respectively. Thus, the sum of electron affinity and bandgap of the second barrier modulation layer BML2 is 8.9 eV. The potential barrier of electrons between the SiO₂ tunneling barrier layer and the second barrier modulation layer BML2 is 4.45 eV, and this is greatly increased compared to the case of FIG. 4A, but the potential barrier of holes is greatly decreased compared to the case of FIG. 4A.

As described above, the first barrier modulation layer BML1 having high electron affinity and a low bandgap compared to the SiO₂ tunneling barrier layer and the SiN charge trap layer and having the sum of electron affinity and a bandgap of 8 eV or less, may be between the SiO₂ tunneling barrier layer and the SiN charge trap layer, so that the potential barrier of electrons may be effectively enhanced and as such, the retention characteristics in the erasing operation state may be enhanced.

The following [Table 1] shows electron affinity and a bandgap of exemplary materials.

**[Table 1]**

| | Electron Affinity | Bandgap |
|---|---|---|
| SiN | 2.15 | 5.1 |
| TiO₂ | 2.95 | 3.5 |
| Ta₂O₅ | 3.2 | 4.2 |
| SrTiO₅ | 3.9 | 3.3 |
| ZnO | 4.6 | 3.4 |
| SnO₂ | 4.9 | 3.6 |
| In₂O₃ | 5.4 | 3.5 |

Referring to [Table 1], a material having high electron affinity and a low bandgap compared to the SiO₂ tunneling barrier layer and the SiN charge trap layer and having the sum of electron affinity and a bandgap of 8 eV or less may be, for example, TiO₂, Ta₂O₅, SrTiOs, or ZnO.

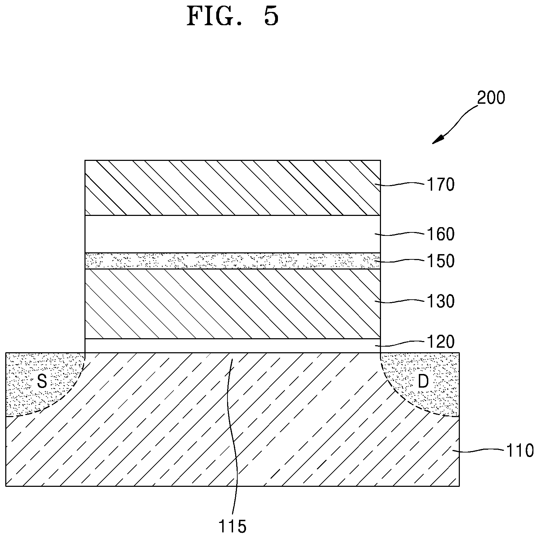

FIG. 5 is a cross-sectional view schematically illustrating a semiconductor device 200 according to some example embodiments. Hereinafter, differences between the present embodiment and the above-described embodiment will be described.

Referring to FIG. 5, a semiconductor device 200 may include a semiconductor substrate 110, a ferroelectric layer 130, a barrier modulation layer 150, a tunneling barrier layer 160, and a gate electrode 170. An interfacial layer 120 may be formed on the surface of the semiconductor substrate 110.

The ferroelectric layer 130 may be between the semiconductor substrate 110 and the gate electrode 170. The ferroelectric layer 130 may include, for example, at least one of a fluorite-based material, perovskite, or a nitride-based material. For example, the ferroelectric layer may include at least one of HfO, ZrO, or HfZrO. The tunneling barrier layer 160 may be between the ferroelectric layer 130 and the gate electrode 170. The tunneling barrier layer 160 may include, for example, silicon oxide (SiO₂) and/or aluminum oxide (Al₂O₃).

The barrier modulation layer 150 may be between the tunneling barrier layer 160 and the ferroelectric layer 130. The barrier modulation layer 150 may include a material having high electron affinity and a low bandgap compared to both the tunneling barrier layer 160 and the ferroelectric layer 130, so as to increase the potential barrier of electrons. The barrier modulation layer 150 may include a material in which the sum of electron affinity and a bandgap is 8 eV or less. However, embodiments are not limited thereto. The barrier modulation layer 150 may include, for example, at least one of TiO₂, Ta₂O₅, SrTiOs, or ZnO. The barrier modulation layer 150 may have a thickness of about 0.1 nm to about 5 nm, but embodiments are not limited thereto.

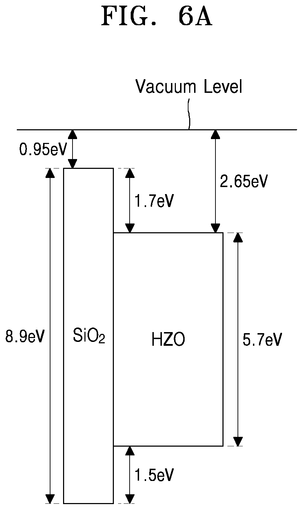

FIGS. 6A through 6C illustrate band diagrams of semiconductor devices including a SiO₂ tunneling barrier layer and a HZO ferroelectric layer. "HZO" represents hafnium-zirconium oxide.

FIG. 6A illustrates a band diagram or Fermi diagram of a semiconductor device in which there is no barrier modulation layer between the SiO₂ tunneling barrier layer and the HZO ferroelectric layer. Referring to FIG. 6A, the electron affinity and a bandgap of the SiO₂ tunneling barrier layer are 0.95 eV and 8.9 eV, respectively. The electron affinity and a bandgap of the HZO ferroelectric layer are 2.65 eV and 5.7 eV, respectively. The potential barrier of electrons between the SiO₂ tunneling barrier layer and the HZO ferroelectric is 1.7 eV, and the potential barrier of holes is 1.5 eV.

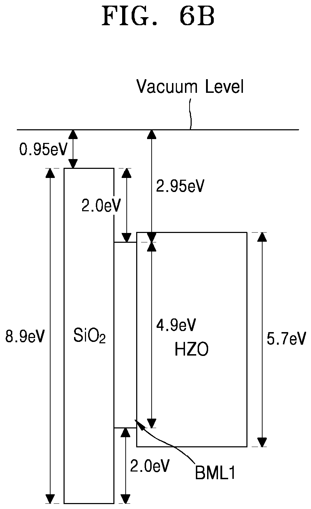

FIG. 6B illustrates a band diagram of a semiconductor device in which a first barrier modulation layer BML1 is between the SiO₂ tunneling barrier layer and the HZO ferroelectric layer. Referring to FIG. 6B, the first barrier modulation layer BML1 may have high electron affinity and a low bandgap compared to the SiO₂ tunneling barrier layer and the HZO ferroelectric layer. Specifically, the electron affinity and bandgap of the first barrier modulation layer BML1 is 2.95 eV and 4.9 eV, respectively. Thus, the sum of electron affinity and a bandgap of the first barrier modulation layer BML1 is 7.85 eV. The potential barrier of electrons between the SiO₂ tunneling barrier layer and the first barrier modulation layer BML1 is 2.0 eV, and this is increased compared to the case of FIG. 6A.

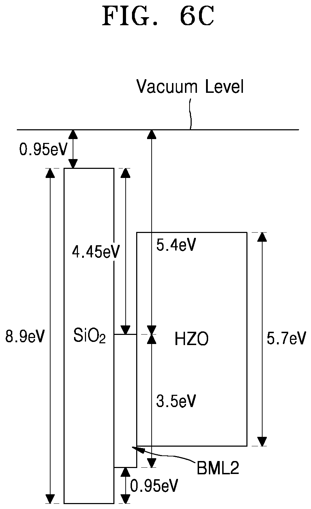

FIG. 6C illustrates a band diagram of a semiconductor device in which a second barrier modulation layer BML2 is between the SiO₂ tunneling barrier layer and the HZO ferroelectric layer. Referring to FIG. 6C, the second barrier modulation layer BML2 has high electron affinity and a low bandgap compared to the SiO₂ tunneling barrier layer and to the HZO ferroelectric layer. Specifically, the electron affinity and a bandgap of the second barrier modulation layer BML2 are 5.4 eV and 3.5 eV, respectively. Thus, the sum of electron affinity and a bandgap of the second barrier modulation layer BML2 is 8.9 eV. The potential barrier of electrons between the SiO₂ tunneling barrier layer and the second barrier modulation layer BML2 is 4.45 eV, and this is greatly increased compared to the case of FIG. 6A, but the potential barrier of holes is 0.95 eV, and this is greatly decreased compared to the case of FIG. 6A.

As described above, the first barrier modulation layer BML1 having high electron affinity and a low bandgap compared to the SiO₂ tunneling barrier layer and the HZO ferroelectric layer and the sum of electron affinity and bandgap of 8 eV or less is between the SiO₂ tunneling barrier layer and the HZO ferroelectric charge trap layer, so that the potential barrier of electrons may be effectively enhanced and as such, the retention characteristics in the erase operation state may be enhanced.

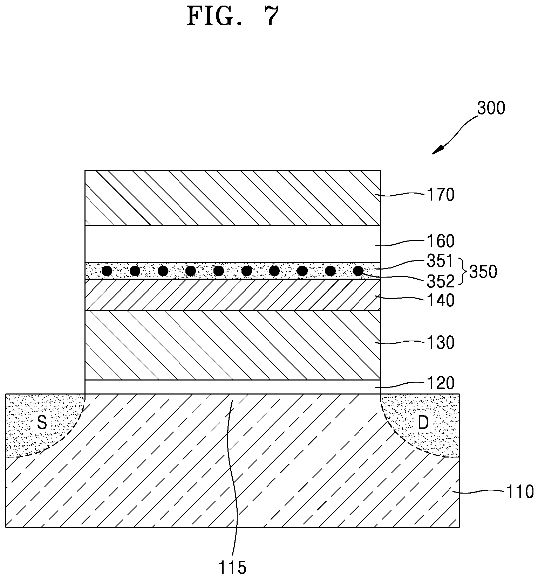

FIG. 7 is a cross-sectional view schematically illustrating a semiconductor device 300 according to some example embodiments. Hereinafter, differences between example embodiments illustrated in FIG. 7 and the above-described embodiments will be described.

Referring to FIG. 7, a semiconductor device 300 may include a semiconductor substrate 110, a ferroelectric layer 130, a charge trap layer 140, a barrier modulation layer 350, a tunneling barrier layer 160, and a gate electrode 170. An interfacial layer 120 may be formed on the surface of the semiconductor substrate 110.

The ferroelectric layer 130 may be between the semiconductor substrate 110 and the gate electrode 170. The tunneling barrier layer 160 may be between the ferroelectric layer 130 and the gate electrode 170, and the charge trap layer 140 may be between the tunneling barrier layer 160 and the ferroelectric layer 130. The tunneling barrier layer 160 may include, for example, silicon oxide (SiO₂) and/or aluminum oxide (Al₂O₃). The charge trap layer 140 may include, for example, silicon nitride (SiN). However, embodiments are not limited thereto.

The barrier modulation layer 350 may be between the tunneling barrier layer 160 and the charge trap layer 140. The barrier modulation layer 350 may include a matrix 351 and metallic nanocrystals 352 dispersed (e.g., homogenously dispersed) in the matrix 351. The matrix 351 may serve to increase the potential barrier of electrons, and the matrix 351 and the barrier modulation layer (see 150 of FIG. 1) in the above-described example embodiment may have the same material. For example, the matrix 351 may include a material having high electronic affinity and a low bandgap compared to the tunneling barrier layer 160 and the charge trap layer 140. The matrix 351 may include a material in which the sum of electron affinity and a bandgap is 8 eV or less. The matrix 351 may include, for example, one or more of TiO₂, Ta₂O₅, SrTiOs, or ZnO.

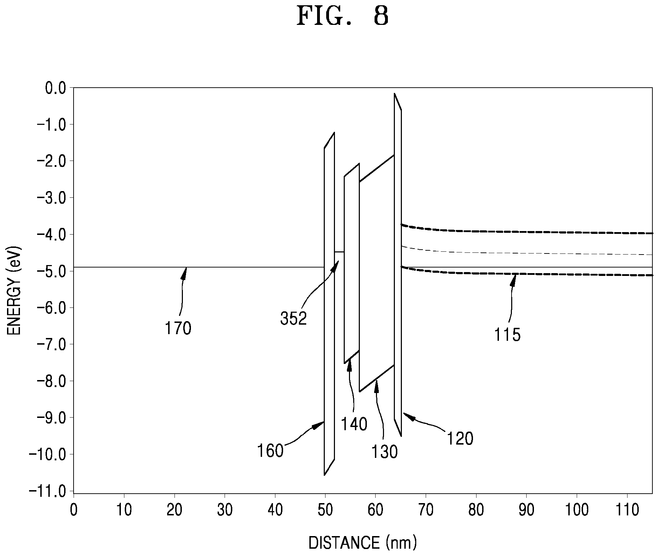

The metallic nanocrystals 352 may serve to further increase the potential barrier of electrons by restraining the electrons inside. FIG. 8 illustrates a band diagram of the semiconductor device 300 shown in FIG. 7. As shown in FIG. 8, the potential barrier of the electrons may be more effectively increased in a region where the metallic nanocrystals 352 are present. The barrier modulation layer 350 may have a thickness of about 0.1 nm to about 5 nm, but embodiments are not limited thereto.

As described above, the case where the semiconductor device 300 includes the charge trap layer 140, has been described. However, a semiconductor device may not include a charge trap layer. In this case, the barrier modulation layer 350 including the matrix 351 and the metallic nanocrystals 352 may be between the tunneling barrier layer 160 and the ferroelectric layer 130. Here, the matrix 351 may include a material having high electronic affinity and a low bandgap compared to the tunneling barrier layer 160 and the ferroelectric layer 130.

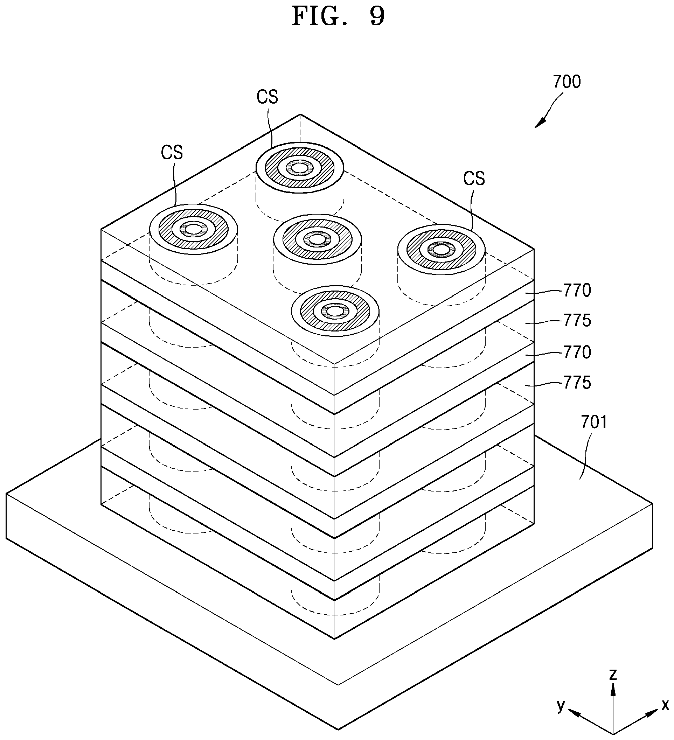

FIG. 9 is a cross-sectional view schematically illustrating a memory device 700 according to some example embodiments. The memory device 700 shown in FIG. 9 may be a vertical NAND flash memory device.

Referring to FIG. 9, the memory device 700 may include a plurality of cell arrays CS arranged on the substrate 701. Here, each of the plurality of cell arrays CS may be arranged to extend in a direction (z-axis direction in FIG. 9) perpendicular to the substrate 701 (or to an upper surface of the substrate 701). The plurality of cell arrays CS may be arranged on the substrate 701 in various forms, such as in a lattice, such as a rectangular lattice or square lattice or triangular lattice or hexagonal lattice.

An interlayer insulating layer 775 and a gate electrode 770 may be alternately stacked on the substrate 701 in the direction perpendicular to the substrate 701. Each interlayer insulating layer 775 and each gate electrode 770 may be arranged on the substrate 701 in parallel. The substrate 701 may include various materials. For example, the substrate 701 may include a monocrystalline silicon substrate, a compound semiconductor substrate, or a silicon on insulator (SOI) substrate, but embodiments are not limited thereto. Also, an electronic device such as an impurity area defined by doping, an electronic device such as a transistor and/or a diode, etc., and/or a periphery circuit for selecting and controlling memory cells MC for storing data may be further arranged on the substrate 701.

The gate electrode 770 may include, for example, metal materials having excellent electrical conductivity such as gold (Au), metal nitride, silicon doped with impurities, or 2D conductive materials, or the like. However, this is just an example, and the gate electrode 770 may include other various materials. Word lines or row lines may be electrically connected to the gate electrode 770.

The interlayer insulating layer 775 may serve as a spacer layer for insulation between the gate electrodes 770. The interlayer insulating layer 775 may include, for example, silicon oxide, silicon nitride, or the like, but embodiments are not limited thereto. Channel holes may be formed in the interlayer insulating layers 775 and the gate electrodes 770 to perforate in the direction (z-axis direction) perpendicular to the substrate 701. Each of the channel holes may be formed to have a circular cross-section, for example. As described below, a tunneling barrier layer 760, a barrier modulation layer 750, a charge trap layer 740, a ferroelectric layer 730, and a channel layer 715 may be sequentially arranged on inner walls of the channel holes.

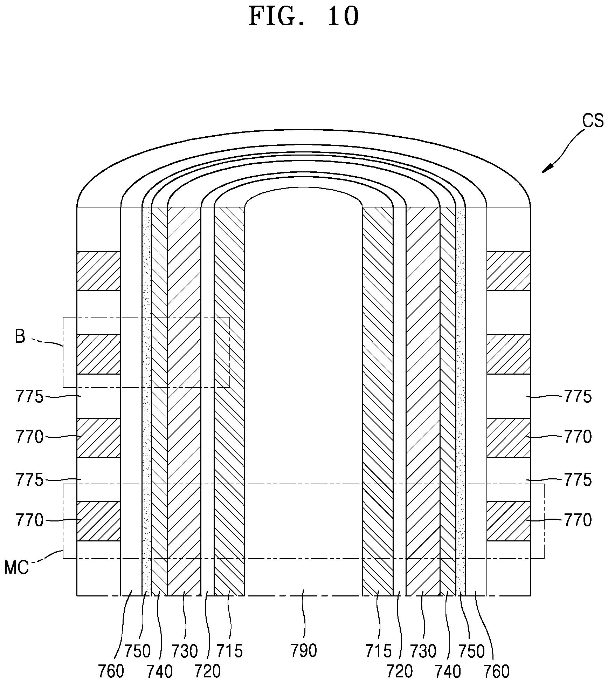

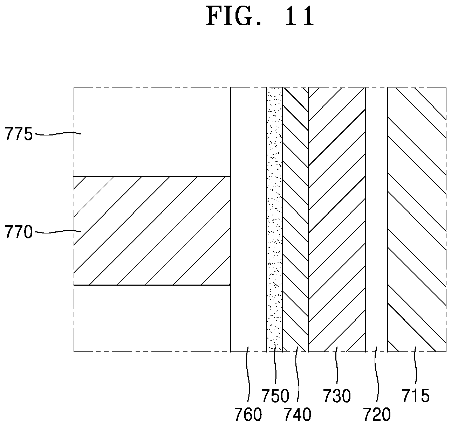

FIG. 10 illustrates the cross-section of the cell array CS shown in FIG. 9, and FIG. 11 is an enlarged view of a portion B of FIG. 10.

Referring to FIGS. 10 and 11, each cell array CS may include a plurality of memory cells MC stacked in the direction (z-axis direction) perpendicular to the substrate 701. The cell array CS may include a plurality of gate electrodes 770 stacked to be spaced apart from one another in the direction perpendicular to the substrate 701 with the interlay insulation layers 775 therebetween, and a tunneling barrier layer 760, a barrier modulation layer 750, a charge trap layer 740, a ferroelectric layer 730, and a channel layer 715, which are sequentially arranged inside the gate electrodes 770 and are perpendicular to the substrate 701.. The number of and/or the thickness of each of the gate electrodes 770 and the interlayer insulating layers 775 are not limited thereto; for example, a thickness of at least one gate electrode 770 may be different from other gate electrodes 770, and/or a thickness of at least one interlay insulating layer 775 may be different from other interlayer insulating layers 775. Each of the tunneling barrier layer 760, the barrier modulation layer 750, the charge trap layer 740, the ferroelectric layer 730, and the channel layer 715 may be arranged to extend perpendicular to the substrate 701 and may be shared by the plurality of memory cells MC. An interfacial layer 720 may be further provided between the channel layer 715 and the ferroelectric layer 730. A filling insulating layer 790 may be provided inside the channel layer 715 to fill channel holes. The filling insulating layer 790 may include, for example, silicon oxide or air, but embodiments are not limited thereto.

Each memory cell MC may include gate electrodes 770, and a tunneling barrier layer 760, a barrier modulation layer 750, a charge trap layer 740, a ferroelectric layer 730, and a channel layer 715, which are arranged to correspond to the gate electrodes 770. A source and a drain may be provided below and above the channel layer 715, respectively, and a channel corresponding to each of the gate electrodes 770 may be formed on the channel layer 715 between the source and the drain.

The channel layer 715 may include semiconductor materials. For example, the channel layer 715 may include, for example, Si, Ge, SiGe, III-V-group semiconductor, and the like. Also, the channel layer 715 may include, for example, one or more of an oxide semiconductor, a nitride semiconductor, an oxynitride semiconductor, a 2D semiconductor material, a quantum dot, or an organic semiconductor. Here, the oxide semiconductor may include, for example, InGaZnO, or the like and the 2D semiconductor material may include, for example, one or more of transition metal dichalcogenide (TMD) or graphene, and the quantum dot may include a colloidal QD, a nanocrystal structure, or the like. However, this is just an example, and embodiments are not limited thereto.

The channel layer 715 may further include a dopant. Here, the dopant may include a p-type dopant or a n-type dopant. The p-type dopant may include, for example, a group-III element such as one or more of B, Al, Ga, In or the like, and the n-type dopant may include, for example, a group-V element such as one or more of P, As, Sb or the like. In various example embodiments, the ferroelectric layer 730, the charge trap layer 740, the barrier modulation layer 750, and the tunneling barrier layer 760 may be the same as in example embodiments shown in FIG. 1, and thus detailed descriptions thereof will be omitted.

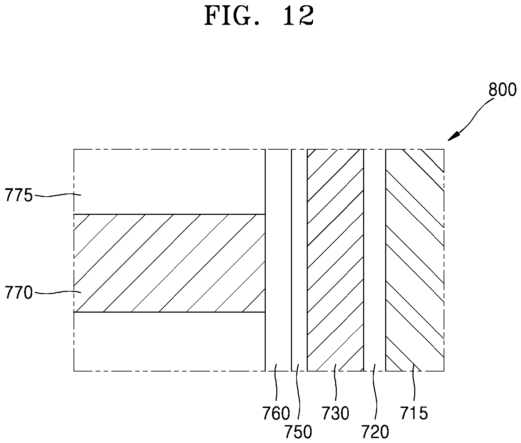

FIG. 12 is a cross-sectional view of a memory device 800 according to some example embodiments. FIG. 12 illustrates only a main portion of a memory cell that constitutes or is included in the memory device 800 for convenience, and is the same below.

Referring to FIG. 12, a tunneling barrier layer 760, a barrier modulation layer 750, a ferroelectric layer 730, and a channel layer 715 are sequentially stacked on the gate electrode 770. Since the channel layer 715, the ferroelectric layer 730, the barrier modulation layer 750, the tunneling barrier layer 760 and the gate electrode 770 are the same as in the embodiment shown in FIG. 5, detailed descriptions thereof will be omitted.

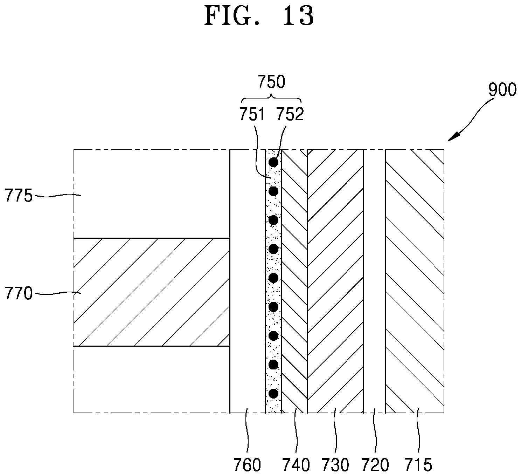

FIG. 13 is a cross-sectional view of a memory device 900 according to some example embodiments.

Referring to FIG. 13, a tunneling barrier layer 760, a barrier modulation layer 750, a charge trap layer 740, a ferroelectric layer 730, and a channel layer 715 may be sequentially stacked on a gate electrode 770. Here, the barrier modulation layer 750 may include a matrix 751 and metallic nanocrystals 752 dispersed (e.g., homogenously dispersed) in the matrix 751. Since the channel layer 715, the ferroelectric layer 730, the charge trap layer 740, the barrier modulation layer 750, the tunneling barrier layer 760 and the gate electrode 770 may be the same as in the embodiment shown in FIG. 7, and thus detailed descriptions thereof will be omitted. On the other hand, the charge trap layer 740 may not be provided in FIG. 13.

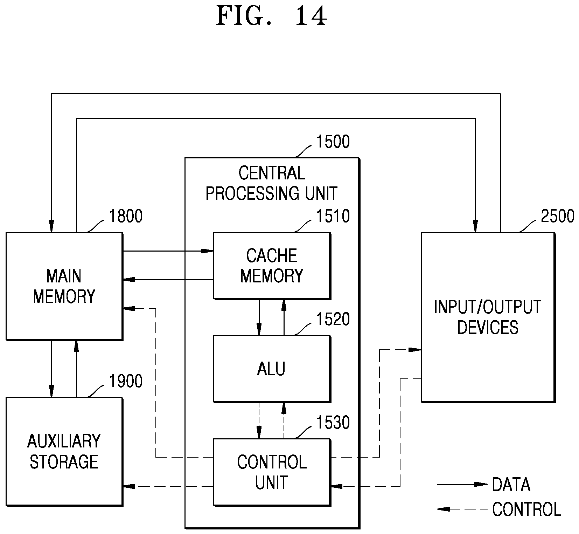

The memory devices 100, 200, 300, 700, 800, and 900 according to embodiments as described above may be used for data storage in various electronic apparatuses. FIG. 14 is a conceptual view schematically illustrating a device architecture that may be applied to an electronic apparatus.

Referring to FIG. 14, cache memory 1510, an arithmetic logic unit (ALU) 1520, and a control unit 1530 may constitute a central processing unit (CPU) 1500, and the cache memory 1510 may include static random access memory (SRAM). Apart from the CPU 1500, main memory 1800 and an auxiliary storage 1900 may also be provided. Input/output devices 2500 may also be provided. The main memory 1800 may include a dynamic random access memory (DRAM) device, and the auxiliary storage 1900 may include one or more of the above-described memory devices 100, 200, 300, 700, 800, or 900. In some cases, the device architecture may be implemented in a shape in which computing unit elements and memory unit elements are arranged adjacent to one another in one chip regardless of classification of sub-units.

The memory devices 100, 200, 300, 700, 800, and 900 according to the above-described embodiments may be implemented in a chip-type memory block and may be used as a neuromorphic computing platform, or may be used to form a neural network.

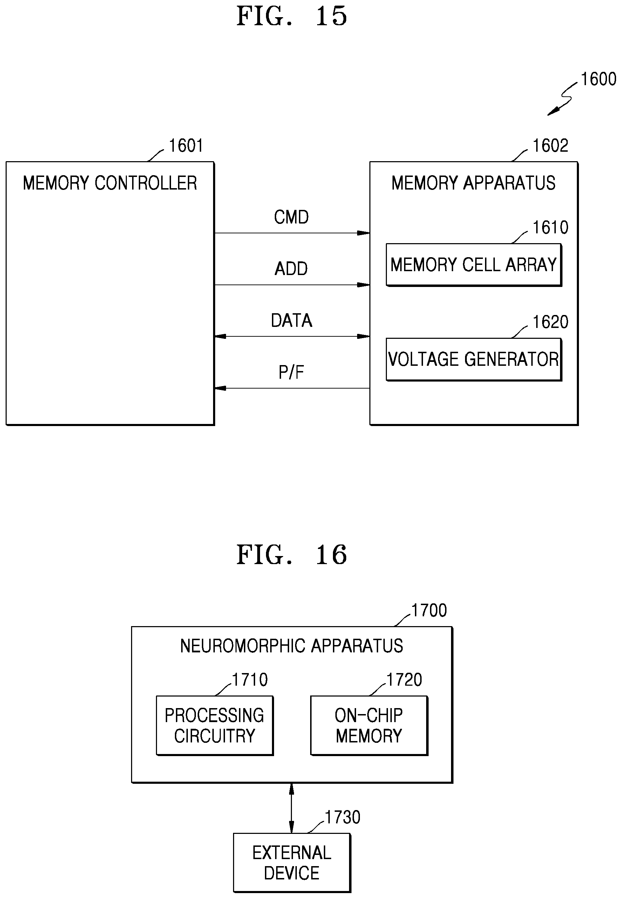

FIG. 15 is a block diagram illustrating a memory system 1600 according to some example embodiments.

Referring to FIG. 15, the memory system 1600 may include a memory controller 1601 and a memory apparatus 1602. The memory controller 1601 may perform a control operation of the memory apparatus 1602, and for example, the memory controller 1601 may provide addresses ADD and commands CMD for executing programming (or recording), reading and/or erasing operations on the memory apparatus 1602, to the memory apparatus 1602. Alternatively or additionally, data for a programming operation and a reading operation may be transmitted between the memory controller 1601 and the memory apparatus 1602.

The memory apparatus 1602 may include a memory cell array 1610 and a voltage generator 1620. The memory cell array 1610 may include a plurality of memory cells, and may include one or more of memory devices 100, 200, 300, 700, 800, and 900 according to embodiments described above.

The memory controller 1601 may include a processing circuitry such as hardware including a logic circuit, a hardware/software combination such as processor executing software, or a combination thereof. For example, the processing circuitry may include, more specifically, a CPU, an ALU, a digital signal processor, a microcomputer, a field programmable gate array (FPGA), a system-on-chip (SoC), a programmable logic unit, a microprocessor, an application-specific integrated circuit (ASIC), or the like. However, embodiments are not limited thereto. The memory controller 1601 may operate in response to a request from a host (not shown), access the memory apparatus 1602 and control the control operation (e.g., a writing/reading operation) discussed above, thereby being configured to convert the memory controller 1601 into a special purpose controller. The memory controller 1601 may generate addresses ADD and commands CMD for performing a programming/reading/erasing operations on the memory cell array 1610. Also, the voltage generator 1620 (e.g., a power circuit) may generate voltage control signals for controlling voltage levels of word lines for data programming or data reading on the memory cell array 1610 in response to instructions from the memory controller 1601.

Also, the memory controller 1601 may perform a determining operation on data read from the memory apparatus 1602. For example, the number of on-cells and/or off-cells may be determined from the data read from the memory cell. The memory apparatus 1602 may provide a pass/fail signal P/F to the memory controller 1601 according to the read result of the read data. The memory controller 1601 may control writing and reading operations of the memory cell array 1610 by referring to the pass/fail signal P/F.

FIG. 16 is a block diagram illustrating a neuromorphic apparatus 1700 and an external device connected to the neuromorphic apparatus 1700, according to some example embodiments.

Referring to FIG. 16, the neuromorphic apparatus 1700 may include a processing circuitry 1710 and/or an on-chip memory 1720. The neuromorphic apparatus 1700 may include one or more memory devices 100, 200, 300, 700, 800, and 900 according to the above-described embodiments.

In some example embodiments, the processing circuitry 1710 may be configured to control a function for driving the neuromorphic apparatus 1700. For example, the processing circuitry 1710 may be configured to control the neuromorphic apparatus 1700 by executing a program stored in the on-chip memory 1720. In some embodiments, the processing circuitry 1710 may include a hardware such as a logic circuit, a hardware/software combination such as a processor for executing software, or a combination thereof. For example, the processor may include a CPU, a graphics processing unit (GPU), an application processor (AP) included in the neuromorphic apparatus 1700, an ALU, a digital signal processor, a microcomputer, a FPGA, a SoC, a programmable logic unit, a microprocessor, an application-specific integrated circuit (ASIC) or the like. However, embodiments are not limited thereto. In some example embodiments, the processing circuitry 1710 may be configured to read/write various data from/into the external device 1730 and/or to execute the neuromorphic apparatus 1700 by using the read/written data. In some example embodiments, the external device 1730 may include external memory and/or a sensor array with an image sensor (e.g., a complementary metal oxide semiconductor (CMOS) image sensor circuit).

In some example embodiments, the neuromorphic apparatus 1700 of FIG. 16 may be applied to a machine learning system. The machine learning system may use various artificial neural network organization and processing models, such as a repetitive neural network (RNN) optionally including a convolutional neutral network (CNN), a deconvolution neural network, a long short-term memory (LSTM) unit and/or a gated recurrent unit (GRU), a stacked neural network (SNN), a state-space dynamic neural network (SSDNN), deep Belief network (DBN), generative adversarial network (GAN) and/or a restrictive Boltzmann machine.

Alternatively or additionally, these machine learning systems may include different types of machine learning models such as linear and/or logistic regression, statistical clustering, Bayesian classification, crystal tree, dimension reduction such as main component analysis, a professional system and/or a combination thereof including an ensemble such as random forests. Such machine learning models may be used to provide a variety of services and/or applications, for example, image classification services, user authentication services based on biometrics or biometric data, advanced driver assistance system (ADAS) services, voice assistant services, automatic sound recognition (ASR) services, etc.

According to various example embodiments described above, a barrier modulation layer including a material having high electron affinity and a low bandgap may be inserted between a tunneling barrier layer and a charge trap layer or between the tunneling barrier layer and a ferroelectric layer, so that the potential barrier of electrons may be enhanced and thus, the retention characteristics of a memory device in an erasing operation state may be enhanced. The above-described memory devices 100, 200, 300, 700, 800, and 900 have been described by reference to the embodiments shown in the drawings, but this is just an example, and it will be understood by those skilled in the art that a variety of modifications and other equivalent embodiments therefrom are possible.

Any of the elements and/or functional blocks disclosed above may include or be implemented in processing circuitry such as hardware including logic circuits; a hardware/software combination such as a processor executing software; or a combination thereof. For example, the processing circuitry more specifically may include, but is not limited to, a central processing unit (CPU), an arithmetic logic unit (ALU), a digital signal processor, a microcomputer, a field programmable gate array (FPGA), a System-on-Chip (SoC), a programmable logic unit, a microprocessor, application-specific integrated circuit (ASIC), etc. The processing circuitry may include electrical components such as at least one of transistors, resistors, capacitors, etc. The processing circuitry may include electrical components such as logic gates including at least one of AND gates, OR gates, NAND gates, NOT gates, etc.

It should be understood that various example embodiments described herein should be considered in a descriptive sense only and not for purposes of limitation. Descriptions of features or aspects within each embodiment should typically be considered as available for other similar features or aspects in other embodiments. While one or more embodiments have been described with reference to the figures, it will be understood by those of ordinary skill in the art that various changes in form and details may be made therein without departing from the scope as defined by the following claims.

## Claims

1. A semiconductor device comprising:
a channel layer;
a ferroelectric layer on the channel layer;
a barrier modulation layer on the ferroelectric layer;
a tunneling barrier layer on the barrier modulation layer; and
a gate electrode on the tunneling barrier layer,
wherein the barrier modulation layer is configured to have high electron affinity compared to the tunneling barrier layer and to have a low bandgap compared to the tunneling barrier layer.

2. The semiconductor device of claim 1, wherein the barrier modulation layer comprises a material in which a sum of electron affinity and a bandgap is 8 eV or less.

3. The semiconductor device of claim 2, wherein the barrier modulation layer comprises at least one of TiO₂, Ta₂O₅, SrTiOs, or ZnO.

4. The semiconductor device of claim 1, wherein the barrier modulation layer has a thickness of 0.1 nm or more to 5 nm or less.

5. The semiconductor device of any preceding claim, wherein the barrier modulation layer further comprises metallic nanocrystals.

6. The semiconductor device of any preceding claim, wherein the tunneling barrier layer comprises at least one of silicon oxide or aluminum oxide.

7. The semiconductor device of any preceding claim, wherein the charge trap layer comprises silicon nitride.

8. The semiconductor device according to any preceding claim,: wherein the barrier modulation layer is configured to have high electron affinity compared to the tunneling barrier layer and the ferroelectric layer and to have a low bandgap compared to the tunneling barrier layer and the ferroelectric layer.

9. The semiconductor device of any preceding claim, further comprising:
a charge trap layer between the ferroelectric layer and the barrier modulation layer.

10. The semiconductor device of claim 9, wherein the charge trap layer comprises silicon nitride.

11. The semiconductor device of claim 9 or 10, wherein the barrier modulation layer is configured to have high electron affinity compared to the tunneling barrier layer and the charge trap layer and to have a low bandgap compared to the tunneling barrier layer and the charge trap layer.

12. A memory device comprising:
a plurality of cell arrays,
wherein each of the plurality of cell arrays comprises a semiconductor device according to any preceding claim.

13. The memory device of claim 12, wherein the plurality of gate electrodes are stacked perpendicular to the substrate.
